# EUROPÄISCHE PATENTANMELDUNG

(11) **EP 1 220 337 A1**
(43) Veröffentlichungstag der Anmeldung: **03.07.2002**
(21) Anmeldenummer: 00811246.8
(22) Anmeldetag: 27.12.2000
(51) Int. Cl.: H01L 39/16

(54) **Supraleitender Strombegrenzer**

(71) Anmelder: ABB RESEARCH LTD., 8050 Zürich (CH)
(72) Erfinder: Chen, Makan, 5405 Baden-Dättwil (CH); Paul, Willi, 5430 Wettingen (CH); Unternaehrer, Peter, 5436 Würenlos (CH)
(74) Vertreter: ABB Patent Attorneys

(57) **Zusammenfassung**

Resistive Strombegrenzer auf Supraleiterbasis umfassen Module (2), welche wiederum aus zwei die supraleitenden Leiterbahnen (40,40') enthaltenden plattenförmige Elementen (4,4') aufgebaut sind. Zwischen den Elementen befindet sich ein Isolator (5) welcher zur Minimierung der Wechselstromverluste möglichst dünn ausgebildet sein muss. Erfindungsgemäss wird als Isolator eine Polymerfolie eingesetzt, welche auch bei 77 K eine ausreichende elektrische Durchschlagsfestigkeit aufweist, um die insbesondere bei seriegeschalteten Elementen im Begrenzungsfall auftretenden hohen Spannungen auszuhalten. Die Polymerfolie wird mit einer Klebschicht (6) aus einem Faserverbund an die Elemente angeklebt.

## Beschreibung

### TECHNISCHES GEBIET

Die vorliegende Erfindung bezieht sich auf das Gebiet der Hochtemperatursupraleitung. Sie betrifft einen supraleitenden Strombegrenzer gemäss dem Oberbegriff des Patentanspruchs 1.

### STAND DER TECHNIK

Hochtemperatursupraleiter finden beispielsweise Verwendung in supraleitenden Kurzschluss-Strombegrenzern in elektrischen Verteil- oder Übertragungsnetzen. Bei einem solchen Strombegrenzer wird ausgenutzt, dass ein Supraleiter bei entsprechend tiefer Temperatur seine Supraleitfähigkeit nur solange beibehält, als die Stromdichte eines ihn durchfliessenden Stromes unterhalb eines gewissen, als kritische Stromdichte (j_{c}) bezeichneten Grenzwertes bleibt. Im Kurzschluss- oder Begrenzungsfall "quencht" der Supraleiter, d.h. er erwärmt sich über die kritische Temperatur T_{c} und tritt in den resistiven Zustand über, und die am zu schützenden Netzabschnitt anliegende Spannung fällt über dem Strombegrenzer ab.

In Supraleitern treten im Dauerbetrieb Wechselstromverluste auf, auch wenn die Amplitude des Nennstromes I_{N} kleiner als der kritische (Gleich-)Strom I_{C} ist. Diese Verluste sind eine Folge von bestimmten Magnetfeldkomponenten innerhalb des Supraleiters und werden dadurch verringert, indem die genannten Magnetfelder unterdrückt oder kompensiert werden. Dies wiederum geschieht bei bandförmigen Supraleitern mit einem grossen Querschnittsverhältnis von Breite zu Höhe geeigneterweise durch einen zweiten Supraleiter mit einem annähernd gleich grossen, aber in entgegengesetzter Richtung fliessenden Strom, welcher in geringem Abstand zum ersten Supraleiter angeordnet wird.

In der DE 44 34 819 A1 ist ein Strombegrenzer offenbart, bei welchem beidseits eines Isolators je eine Leiterbahn aus einem Leiterverbund umfassend einen Hochtemperatursupraleiter und einen Normalleiter, welcher mit dem Supraleiter flächenhaft verbunden ist und einen elektrischen Bypass für diesen darstellt, angeordnet ist. In einander direkt gegenüberliegenden Abschnitten der Leiterbahnen fliesst der Strom in entgegengesetzter Richtung. In diesem Fall sind bei ausreichend flach ausgebildeten Leitern die Wechselstromverluste umso stärker reduziert, je geringer der Abstand zwischen den beiden Leiterbahnen, d.h. je dünner der sie trennende Isolator ist.

Polykristalline schmelzprozessierte Supraleiterkeramiken vom Typ Bi₂Sr₂CaCu₂O₈, wie sie in der genannten DE 44 34 819 A1 eingesetzt werden, sind mit für Strombegrenzeranwendungen typischen Schichtdicken von 50-5000 µm nicht selbsttragend. Sie werden beispielsweise durch einen mechanisch beanspruchbaren Träger aus einem glasfaserverstärkten Faserverbundwerkstoff gestützt und geschützt. Letztere enthalten eine Polymermatrix aus ausgehärtetem Epoxidharz und Glas- oder Kohlefasern als verstärkendem Trägergewebe. Glasfaserhaltige Faserverbundstoffe weisen allerdings bei 77 K geringe Teilentladungsfeldstärken (partial discharge inception field) von ≈ 1 kV/mm auf, welche selbst unter Verwendung spezieller Vakuum-Druck Imprägnierverfahren zum Vergiessen der Harzmasse bestenfalls auf ≈ 4 kV/mm gesteigert werden können. Die erzielbaren Durchbruchfeldstärken (breakdown strength) liegen dabei nur unwesentlich über den genannten Teilentladungsfeldstärken.

Für resistive Strombegrenzer werden plattenförmige Elemente fabriziert, welche einen Supraleiter in Form einer quasizweidimensionalen Leiterbahn geringer Höhe, aber für Strombegrenzeranwendungen ausreichender Gesamt-Leiterlänge umfassen. Zwei derartige Elemente werden anschliessend zu einem sogenannten Modul zusammengefügt, wobei die Elemente durch einen Isolator voneinander elektrisch getrennt werden. Wird als Isolator einer der vorgängig genannten Träger auf Faserverbundbasis eingesetzt, darf dieser zur Vermeidung zu grosser elektrischer Feldstärken eine gewisse Mindestdicke nicht unterschreiten, was wiederum einer Reduktion der Wechselstromverluste zuwiderläuft.

### DARSTELLUNG DER ERFINDUNG

Aufgabe der vorliegenden Erfindung ist es, einen Strombegrenzer auf Hochtemperatursupraleiterbasis anzugeben, welcher unter Nennstrom geringe Wechselstromverluste aufweist. Diese Aufgabe wird durch einen Strombegrenzer mit den Merkmalen des Patentanspruchs 1 gelöst.

Kern der Erfindung ist es, bei einem Strombegrenzer in Modulbauweise der eingangs genannten Art zwischen den Leiterbahnen eine elektrische Isolationsschicht vorzusehen, welche eine Polymerfolie umfasst. Im Vergleich zu Faserverbundkompositen weist eine faserfreie Polymerfolie, d.h. eine reine Polymermatrix ohne Zusätze oder Füllmaterialien bei einer Temperatur von 77 K eine erhöhte Durchbruchfeldstärke von über 50 kV/mm auf. Die dielektrische Funktion des Isolators wird also von der mechanischen (Stütz-)funktion getrennt. Dank der verbesserten dielektrischen Eigenschaften ist nur eine reduzierte Isolatorschichtdicke erforderlich, so dass der Abstand zwischen den Leiterbahnen verringert werden kann und die gegenseitige Magnetfeldkompensation und damit die Wechselstromverlustreduktion noch effektiver wird.

In einer ersten Ausführungsform ist zur Erzielung einer dauerhaften Verbindung zwischen der Polymerfolie und der Leiterbahn eine Klebeschicht vorgesehen. Diese ist bevorzugterweise eine Faserverbundschicht, denn beim Aushärten einer Harzmatrix des Faserverbundes, welches bei einer für die Polymerfolie unschädlichen Temperatur erfolgt, ergibt sich eine ausgezeichnete Adhäsionsbindung. Zur weiteren Verbesserung dieser Haftung wird die Polymerfolie vorgängig aktiviert.

Gemäss einer zweiten Ausführungsform sind die beiden Leiterbahnen eines Moduls deckungsgleich und elektrisch in Serie geschaltet. Dies erlaubt eine optimale Magnetfeldkompensation über die gesamte Leiterlänge. Der Einsatz der Polymerfolie ist bei dieser Konfiguration besonders sinnvoll, da im Begrenzungsfall zwischen den Leiterbahnenden maximale Spannungsdifferenzen auftreten. Gleichzeitig ergibt eine Serieschaltung mit einer dünnen Isolatorschicht auch eine niederinduktive Anordnung. Der Einsatz von jeweils zwei identischen Elementen pro Modul hat auch herstellungstechnische Vereinfachungen zur Folge.

Zur optimalen Platzausnutzung sind die beiden Leiterbahnen bevorzugterweise als fortlaufende oder spiralförmige Mäander ausgebildet. Ein rechteckiger spiralförmige Mäander vermeidet dabei die ungünstigen 180°-Wendungen ("U-turns") mit ihren inhomogenen Stromverteilungen und reduzierten effektiven Leiterquerschnitten.

Weitere vorteilhafte Ausführungsformen gehen aus den abhängigen Patentansprüchen hervor.

### KURZE BESCHREIBUNG DER FIGUREN

Nachfolgend wird die Erfindung anhand von Ausführungsbeispielen im Zusammenhang mit den Zeichnungen näher erläutert. Es zeigen
Fig.1a einen Stromkreis und Fig.1b einen Strombegrenzermodul nach dem Stand der Technik,
Fig.2 einen Ausschnitt eines Querschnitts durch ein Strombegrenzermodul nach der Erfindung, und
Fig.3 eine nicht massstabsgetreue Schrägaufsicht eines Moduls mit einer Leiterbahn in Form eines spiralförmigen Mäanders.

Die in den Zeichnungen verwendeten Bezugszeichen sind in der Bezugszeichenliste zusammengefasst. Grundsätzlich sind gleiche Teile mit denselben Bezugszeichen versehen.

### WEGE ZUR AUSFÜHRUNG DER ERFINDUNG

In Fig.1a ist ein Stromkreis 1 mit einer supraleitenden Strombegrenzungsanordnung 2 nach dem Stand der Technik gezeigt. Eine Spannungsquelle 10 erzeugt eine treibende Spannung U₀, welche im Normalfall beim Verbraucher 11 abfällt. Ebenfalls in den Stromkreis geschaltet sind ein Hauptschalter 12 und ein supraleitender Strombegrenzer 2. Solange der Hauptschalter 12 geschlossen bleibt kann, beispielsweise infolge eines Kurzschlusses im Verbraucher 12, die treibende Spannung U₀ auch ausschliesslich am Strombegrenzer 2 abfallen, wodurch dieser in bekannter Weise in seinen normalleitenden Zustand übergeht und den Fehlerstrom begrenzt.

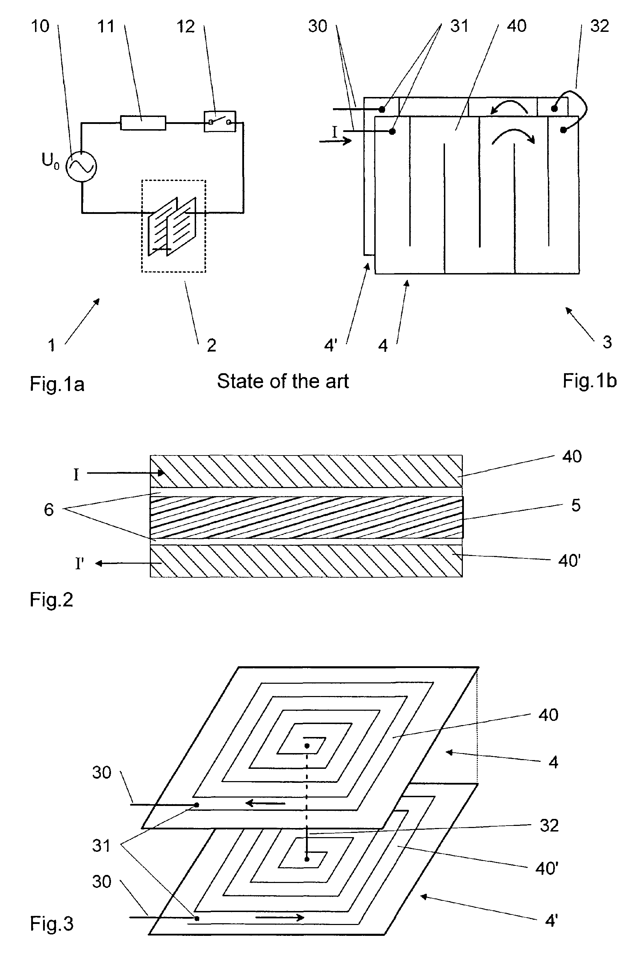

Fig.1b zeigt ein Strombegrenzermodul 3 umfassend ein erstes Element 4 mit einer Leiterbahn 40 in Form eines fortlaufenden, zickzackförmigen Mäanders, ein zweites, identisches Element 4' und einer zwischen den beiden Elementen liegenden, nicht dargestellten Isolationsschicht. An Anschlusskontakten 31 des Moduls 3 sind die Leiterbahnen 40,40' mit normalleitenden Anschlussleitern 30 zur Einspeisung oder Abnahme des zu begrenzenden Stromes kontaktiert. Es wird darauf geachtet, dass die für die Wechselstromverluste massgebenden Magnetfeldkomponenten grösstenteils kompensiert werden, indem die beiden Elemente 4,4' derart angeordnet und im vorliegenden Falle über einen Verbindungsleiter 32 seriegeschaltet werden, dass in zwei gegenüberliegenden Abschnitten der Leiterbahnen 40,40' ein Strom I gleicher Stärke jeweils in entgegengesetzter Richtung fliesst.

In Fig.2 ist ein Teil eines Schnitts durch ein Modul 3 gezeigt. Die beiden Leiterbahnen 40,40' mit antiparalleler Stromflussrichtung sind durch einen Isolator 5 getrennt. Erfindungsgemäss weist dieser Isolator 5 eine hohe Teilentladungs- oder Durchbruchsfeldstärke auf. Als Isolator 5 kommen beispielsweise Polymerfolien aus Polyprolen, Polyvinilchlorid (PVC), Polyvinilformval (PVF) oder insbesondere Polyethylen in Frage. Untersuchungen haben gezeigt, dass diese Materialien bei der geplanten Einsatztemperatur von rund 77 K eine Durchbruchfeldstärke von über 50 kV/mm aufweisen. Sie sind erhältlich als homogene Folien ohne Hohlräume (voids) mit Schichtdicken von 10 bis 100 µm. Da sich die Module im Begrenzungsfall bis auf Raumtemperatur erwärmen und sich dabei die Durchbruchfeldstärke erniedrigt, ist eine einlagige Schicht von 50 µm Dicke zur Isolierung von Modulspannungen bis 1000 V ausreichend. Klebeschichten 6 zwischen den Leiterbahnen 40 und der Polymerfolie 5 ermöglichen einen dauerhaften, kraftschlüssigen Kontakt. Weiter können nicht dargestellte Schichten zur elektrischen Isolierung und mechanischen Stabilisierung auf einer dem Isolator 5 abgewandten Seite eines Leiterverbundes 40,40' vorgesehen sein.

In Fig.3 ist eine Serieschaltung von Leiterbahnen 40,40' in Form von rechteckspiralförmigen Mäandern gezeigt. Der Übersichtlichkeit halber ist der Isolator dabei weggelassen. Gegenüber fortlaufenden Mäandern wie in Fig.1b weisen spiralförmige Mäander den Vorteil auf, dass sie an den Ecken nur 90°-Wendungen aufweisen. Bei den 180°-Wendungen oder "U-turns" gemäss Fig.1b treten nämlich inhomogene Stromdichteverteilungen auf, welche zu einem lokalen Überschreiten der kritischen Stromdichte führen können.

Ein kompakt aufgebauter Strombegrenzer 2 umfasst mehrere in Serie geschaltete Module. Dabei liegt im Begrenzungsfall, wenn die Supraleiter sich über ihre kritische Temperatur erwärmt haben und normalleitend geworden sind, eine sogenannte Modulspannung als entsprechender Bruchteil der gesamten treibenden Spannung U₀ an jedem Modul an. Sind auch die beiden Elemente 4,4' eines Moduls 3 seriegeschaltet, nimmt die Potentialdifferenz zwischen einem Punkt des ersten Elementes 4 und einem unmittelbar gegenüberliegenden Punkt des zweiten Elementes 4' entlang der Leiterbahn ausgehend von der Modulspannung (bei den Anschlusskontakten 31) linear auf Null ab. Insbesondere im Bereich der Anschlusskontakte 31 werden also an die elektrische Isolation 5 entsprechend hohe Anforderungen gestellt. Dabei gilt, dass ausgedehnte grossflächige Elemente 4 mit entsprechend langen Leiterbahnen 40 im Begrenzungsfall einen höheren Widerstand ausbilden und somit grössere Spannungsunterschiede zwischen den Anschlusskontakten 31 auftreten als bei kleineren Elementen. In diesem Sinn ist bei grossflächigen seriegeschalteten Elementen ein Einsatz einer Polymerfolie als Isolator 5 erst recht vorteilhaft.

Bekannte Feststoffisolatoren mit mechanischen Stützfunktionen, welche prinzipiell als Isolatoren 5 geeignet wären, bestehen aus einem Trägergewebe und einer Polymermatrix, basierend beispielsweise auf ausgehärteten Epoxid-, Silizium- oder Polyesterharzen. Der Grund für deren eingangs erwähnte bescheidene Teilentladungsfeldstärke bei 77 K (weniger als 4 kV/mm für imprägnierte Glasfasern oder 10 kV/mm für imprägnierte Zellstofffasern) liegt bei der notwendigen Beschichtung der Fasern, welche eine vollständige Benetzung mit Harz verhindert. Dadurch entstehen mikroskopisch kleine Hohlräume an den Fasern, in welchen Teilentladungen stattfinden, was zu einer beschleunigten Alterung der Glasfaserisolation führt.

Es ist also vorteilhaft, Stütz- und Isolatorfunktion zu trennen und für Letztere eine Polymerfolie ohne Trägergewebe einzusetzen. Zur Anbindung der Isolatorschicht 5 an den Leiterverbund 40 sind jedoch Klebeschichten 6 aus derartigen Faserverbundwerkstoffen geeignet. Der Faserverbundwerkstoff wird dabei hauptsächlich in Form von dünnen Platten, sogenannten Prepregs eingesetzt. Prepregs sind mit Harzformulierungen vorimprägnierte und eventuell vorgehärtete Fasergebilde, die sich einfach verformen und anschliessend unter Druck und Temperatur ganz aushärten lassen. Dabei bildet sich eine ausgezeichnete Adhäsionsbindung zwischen dem Faserverbundwerkstoff und dem daran anschliessenden Material, d.h. im vorliegenden Fall dem Leiterverbund 40 und der Polymerfolie 5. Gleichzeitig soll der Faserverbund aber wegen seiner geringen thermischen Leitfähigkeit möglichst dünn bleiben.

Polymerfolien sind chemisch sehr inert und zum Verkleben wenig geeignet. Zur Verbesserung der Hafteigenschaften werden sie deswegen in einem erfindungsgemässen Verfahren mittels Plasmaoxidation oder chemischem Ätzen aktiviert oder vorbehandelt. Die chemische Bindung zu den Polymeren der benachbarten Klebeschicht wird dadurch entscheidend verstärkt.

Die plattenförmigen Module 3 werden hergestellt, indem die vorpräparierten Bestandteile gemäss Fig.2 angeordnet werden. Der resultierende schichtweise Aufbau umfasst also ein erstes Element 4 mit einer Leiterbahn 40, eine Klebeschicht 6 aus Faserverbundwerkstoffen, einen Isolator 5 aus einer Polymerfolie, eine weitere Klebeschicht und ein zweites Element 4'. Das Supraleitermaterial der Leiterbahnen ist bereits fertig reagiert und somit supraleitend, und die Polymerfolie chemisch aktiviert. Anschliessend wird das Modul (3) mit all seinen Bestandteilen auf eine Aushärtetemperatur des Polymerharzes des Faserverbundes erwärmt und dabei beide Klebeschichten aus Faserverbundwerkstoff in einem Arbeitsgang ausgehärtet.

### BEZUGSZEICHENLISTE

- 1: Stromkreis
- 10: Spannungsquelle
- 11: Verbraucher
- 12: Schalter
- 2: Strombegrenzer
- 3: Modul
- 30: Anschlussleiter
- 31: Anschlusskontakt
- 32: Verbindungsleiter
- 4,4': Element
- 40,40': Leiterbahn
- 5: Isolator
- 6: Klebeschicht

## Patentansprüche

1. Strombegrenzer auf Hochtemperatursupraleiterbasis,
a) umfassend mindestens ein Modul (3), mit einem ersten und einem zweiten Element (4,4'), welche Elemente durch einen Isolator (5) elektrisch getrennt sind, wobei
b) jedes Element (4,4') eine Supraleitermaterial umfassende Leiterbahn (40,40') aufweist, in welcher im Dauerbetrieb ein Nennstrom (I,I') fliesst,
c) die beiden Elemente (4,4') zur Reduktion der Wechselstromverluste derart angeordnet sind, dass sich ihre zwei Leiterbahnen (40,40') in magnetischer Wechselwirkung befinden und die Nennströme in den zwei Leiterbahnen (40,40') zumindest annähernd gleich gross sind und grösstenteils in entgegengesetzte Richtungen fliessen,
**dadurch gekennzeichnet, dass**
d) der elektrische Isolator (5) eine Polymerfolie umfasst.

2. Strombegrenzer nach Anspruch 1, **dadurch gekennzeichnet, dass** zwischen der Polymerfolie (5) und dem ersten oder zweiten Element (4,4') eine Klebeschicht (6) zur kraftschlüssigen Verbindung vorgesehen ist.

3. Strombegrenzer nach Anspruch 2, **dadurch gekennzeichnet, dass** die Klebeschicht (6) eine ausgehärtete Faserverbundschicht ist.

4. Strombegrenzer nach Anspruch 1, **dadurch gekennzeichnet, dass** die zwei Leiterbahnen (40,40') spiralförmig ausgebildet sind.

5. Strombegrenzer nach Anspruch 1, **dadurch gekennzeichnet, dass** die Leiterbahnen (40,40') des ersten und zweiten Elementes (4,4') deckungsgleich angeordnet und elektrisch in Serie geschaltet sind.

6. Strombegrenzer nach Anspruch 5, **dadurch gekennzeichnet, dass** die Leiterbahnen rechteckspiralförmige Mäander bilden.

7. Strombegrenzer nach Anspruch 1, **dadurch gekennzeichnet, dass** die Polymerfolie Polyprolen, Polyvinilchlorid oder Polyethylen umfasst.

8. Strombegrenzer nach Anspruch 1, **dadurch gekennzeichnet, dass** die Module eine Ausdehnung von mehr als 0.05 m² aufweisen.

9. Verfahren zur Herstellung eines Strombegrenzermoduls (3) mit zwei Elementen (4,4'), welche durch einen Isolator (5) elektrisch getrennt sind und Supraleitermaterial enthaltende Leiterbahnen (40) umfassen, **dadurch gekennzeichnet, dass** als Isolator eine Polymerfolie eingesetzt wird, deren Oberflächen aktiviert und über Klebeschichten (6) mit den Elementen (4,4') verbunden werden.

10. Verfahren nach Anspruch 9, **dadurch gekennzeichnet, dass** Klebeschichten (6) aus Faserverbundwerkstoff eingesetzt werden, und ein Modul (3) umfassend in dieser Folge ein erstes Element (4) mit einer supraleitenden Leiterbahn (40), eine ersten Klebeschicht (6), eine aktivierte Polymerfolie (5), eine zweite Klebeschicht (6) und ein zweites Element (4') mit einer supraleitenden Leiterbahn (40') aufgebaut wird und die beiden Klebeschichten (6) aus Faserverbundwerkstoff in einem Arbeitsgang gleichzeitig ausgehärtet werden.
